# EUROPÄISCHE PATENTSCHRIFT

(11) **EP 0 555 538 B1**
(45) Veröffentlichungstag und Bekanntmachung des Hinweises auf die Patenterteilung: **15.01.1997**
(21) Anmeldenummer: 92120270.1
(22) Anmeldetag: 27.11.1992
(51) Int. Cl.: G01R 31/04

(54) **Einrichtung zum Prüfen eines Steckers**
Connecteur test means
Dispositif pour tester un connecteur

(30) Priorität: 13.02.1992 DE 4204283
(43) Veröffentlichungstag der Anmeldung: 18.08.1993
(73) Patentinhaber: TSK Prüfsysteme für elektrische Komponenten GmbH, 32457 Porta Westfalica (DE)
(72) Erfinder: Prokopp,Manfred, W-6980 Wertheim (DE)
(74) Vertreter: Stracke, Alexander, Dipl.-Ing.

(56) Entgegenhaltungen:
- DE-A- 3 701 621
- GB-A- 2 170 962

## Beschreibung

Die vorliegende Erfindung betrifft eine Prüfeinrichtung zum Prüfen eines Steckers gemäß dem Oberbegriff des Anspruches 1.

Eine derartige Prüfeinrichtung ist beispielsweise aus der DE-OS 37 01 621 bekannt.

Dabei ist für jeden vorkommenden Steckertyp eine komplette Prüfeinrichtung erforderlich.

Da in der Praxis jedoch immer nur ein Teil der Prüfeinrichtungen gleichzeitig zum Einsatz kommen, bedeutet der Nichtgebrauch der übrigen Prüfeinrichtungen einen wirtschaftlichen Nachteil. Dies insbesondere auch deshalb, weil die Herstellung einer kompletten Prüfeinrichtung relativ aufwendig und teuer ist.

Dazu gehört auch, daß die Verriegelungseinrichtungen fest mit dem Aufnahmeteil verbunden sind, so daß sie einen integralen Bestandteil darstellen.

Gerade die Verriegelungseinrichtungen müssen jedoch teilweise von ihrem konstruktiven Aufbau her sehr aufwendig gestaltet sein, was besonders bei einer elektrischen oder pneumatischen Betätigung der Fall ist.

Da die Prüfeinrichtungen in einer Vielzahl Verwendung finden, stellt sich die in wirtschaftlicher Hinsicht Unmöglichkeit des Dauerbetriebes der Prüfeinrichtung als besonders nachteilig dar.

Der vorliegenden Erfindung liegt daher die Aufgabe zugrunde, eine Prüfeinrichtung der gattungsgemäßen Art so zu gestalten, daß insbesondere bei einer nicht gleichzeitigen Verwendung von mehreren Prüfeinrichtungen die Wirtschaftlichkeit verbessert wird.

Diese Aufgabe wird erfindungsgemäß durch die im kennzeichnenden Teil des Anspruchs 1 genannten Merkmale gelöst.

Prinzipiell besteht nun die Möglichkeit, die Anzahl der Verriegelungseinrichtungen auf die Menge zu begrenzen, die tatsächlich gleichzeitig im Einsatz ist.

Sowohl bei der Herstellung der Prüfeinrichtungen als auch bei deren Betrieb ergeben sich somit erhebliche Kostenvorteile.

Wie erwähnt sind die Verriegelungseinrichtungen teilweise recht aufwendig gestaltet, so daß die Herstellungskosten entsprechend hoch sind.

Gegenüber dem Stand der Technik kann nun auf die Herstellung einer nicht unerheblichen Anzahl von Verriegelungseinrichtungen verzichtet werden, was naturgemäß zu einer recht gravierenden Kosteneinsparung führt.

Ein weiterer Vorteil der Erfindung liegt darin, daß ein Auswechseln einer defekten Verriegelungseinrichtung nunmehr erheblich einfacher möglich ist, was sich gleichfalls kostengünstig auswirkt, da bislang ein Ausbau einer defekten Verriegelungseinrichtung aus der entsprechenden Prüfeinrichtung umständlich und zeitaufwendig war, demgegenüber eine Demontage nun praktisch gar nicht erforderlich ist.

Zweckmäßig ist es, die Haltemittel sowohl der Verriegelungseinrichtungen als auch der Aufnahmeteile zu standardisieren, so daß jede Verriegelungseinrichtung mit jedem Aufnahmeteil verbindbar ist.

Eine vorteilhafte Ausgestaltung der Erfindung sieht vor, daß als Haltemittel des Aufnahmeteiles Feststellschrauben vorgesehen sind, die sich mit ihrem Kopf an einer Andruckfläche der Verriegelungseinrichtung abstützen, so daß diese festklemmbar ist. Dabei kann die Andruckfläche Bestandteil eines Langloches sein, so daß eine relative Verstellung der Verriegelungseinrichtung gegenüber dem Aufnahmeteil möglich ist.
Es besteht somit die Möglichkeit, unterschiedliche Tiefen der in das Aufnahmeteil eingelassenen Steckeraufnahme entsprechend den Erfordernissen auszugleichen.

Weitere vorteilhafte Ausgestaltungen der Erfindung sind in den Unteransprüchen gekennzeichnet.

Ausführungsbeispiele der Erfindung werden nachfolgend anhand der beigefügten Zeichnungen beschrieben.
Es zeigen:
- Figur 1: eine erfindungsgemäße Prüfeinrichtung in einer geschnittenen Seitenansicht,
- Figur 2: einen Teilschnitt durch eine Vorderansicht,
- Figur 3: eine Draufsicht auf die Prüfeinrichtung nach den Figuren 1 und 2,
- Figur 4: ein weiteres Ausführungsbeispiel einer Verriegelungseinrichtung in einer teilweise geschnittenen Seitenansicht.

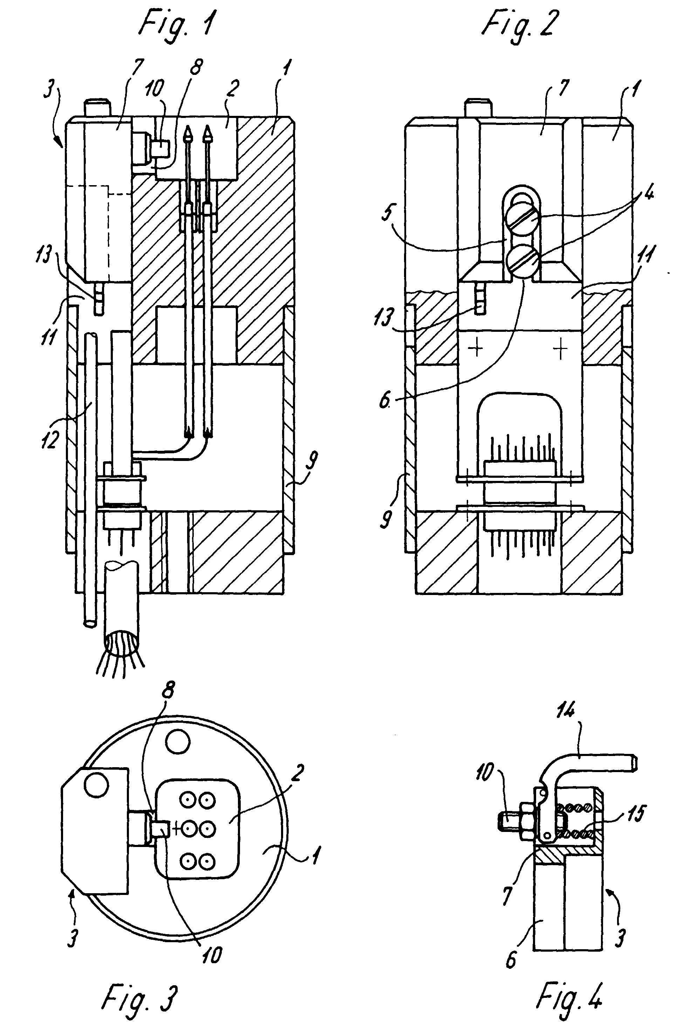

Die in den Figuren 1 - 3 gezeigte Prüfeinrichtung besteht im wesentlichen aus einem Aufnahmeteil 1, das an seiner freien Stirnseite eine Steckeraufnahme 2 aufweist, in die ein mit Kabeln versehener, nicht dargestellter Stecker einsteckbar ist, wobei die Kontur der Steckeraufnahme der Außenkontur des Steckers angepaßt ist.

Im vorliegenden Ausführungsbeispiel ist das Aufnahmeteil 1 in einer Halterung 9 festgelegt, die wiederum ortsfest befestigt sein kann.

In einem Seitenbereich ist das Aufnahmeteil 1, das zylindrisch ausgebildet ist, mit einer eingelassenen Führungsnut 11 versehen, in die ein Gehäuseteil 7 einer Verriegelungseinrichtung 3 einliegt.

Am Grund der Führungsnut 11 sind zwei Feststellschrauben 4 angeordnet, die sich auf einer Andruckfläche 5 des Gehäuseteiles 7 abstützen. Diese Andruckfläche 5 ist Bestandteil eines in Querschnitt T-förmigen Langloches 6, das zu einer Endseite des Gehäuseteiles 7 hin offen ist. Durch axiales Verschieben des Gehäuseteiles 7 kann die Verriegelungseinrichtung 3 in unterschiedlichen Positionen arretiert werden.

Bei dem in den Figuren 1 - 3 gezeigten Ausführungsbeispiel weist die Verriegelungseinrichtung 3 einen druckluftbetriebenen Druckstift 10 auf, der durch eine Ausnehmung 8 des Aufnahmeteiles 1 ragt und Bestandteil eines nicht genauer dargestellten Druckluftzylinders bzw. -kolbens ist, die in dem Gehäuseteil 7 angeordnet sind.

Mit Hilfe des Druckstiftes 10, der in Gebrauchsstellung in die Steckeraufnahme 2 ragt, ist ein darin einliegender Stecker arretierbar.

Unterseitig ist an dem Gehäuseteil 7 eine Tülle 13 angeordnet, an die ein Luftschlauch 12 anschließbar ist, über die den Druckstift 10 betätigende Luft zuführbar ist.

Um die Verriegelungseinrichtung 3 aus dem Aufnahmeteil 1 zu entnehmen, wird nach einem Lösen der Feststellschrauben 4 die Tülle 13 von dem Luftschlauch 12 gezogen.
Statt einer Tülle 13 kann auch ein an sich bekannter Pneumatik-Schnellverschluß vorgesehen sein, bei dem zwischen der Luftzuführungsleitung und einem Luftanschluß des Gehäuseteiles 7 eine sehr einfache Verbindung hergestellt werden kann.

Anstelle des hier dargestellten Ausführungsbeispieles einer Festsetzung der Verriegelungseinrichtung 3 im Aufnahmeteil 1 sind selbstverständlich auch andere Möglichkeiten denkbar, um die Verriegelungseinrichtung 3 zu halten.

Eine sehr einfache Ausführungsvariante der Verriegelungseinrichtung ist in der Figur 4 dargestellt, bei der eine Betätigung des Druckstiftes 10 sowohl in Verriegelungsstellung als auch in Entriegelungsstellung manuell erfolgt.

Dazu ist vorgesehen, daß im Zusammenwirken mit einer im Gehäuseteil 7 einliegenden Druckfeder 15 über einen manuell betätigbaren Befestigungsbügel 14 der Druckstift 10 bewegbar ist. Dem Prinzip nach kann eine Ver- bzw. Entriegelung durch eine Mechanik erfolgen, wie sie unter dem Begriff "Securit-Mechanik" oder "Kugelmechanik" bei Druckkugelschreibern Verwendung findet.

Neben der dargestellten Möglichkeit, das Aufnahmeteil 1 in einer Halterung 9 festzulegen, ist es auch denkbar, das Aufnahmeteil 1 mit einer entsprechenden Halterung unmittelbar an einer Trägerplatte festzulegen. In vielen Fällen reicht eine solche Art der Fixierung aus, die sich dann dadurch auszeichnet, daß sie besonders preiswert herzustellen ist.
1 Aufnahmeteil
2 Steckeraufnahme
3 Verriegelungseinrichtung
4 Feststellschraube
5 Ausdruckfläche
6 Langloch
7 Gehäuseteil
8 Ausnehmung
9 Halterung
10 Druckstift
11 Führungsnut
12 Luftschlauch
13 Tülle
14 Betätigungsbügel
15 Druckfeder

## Patentansprüche

1. Prüfeinrichtung zum Prüfen eines Steckers, der mit Kabeln versehen ist, auf Verrastungs- und/oder Kontaktierungsfehler, mit einem Aufnahmeteil (1), das eine der Außenkontur eines bestimmten Steckers angepaßte Steckeraufnahme (2) aufweist, sowie jeweils einer, in einem oder mehreren Seitenbereichen der Steckeraufnahme (2) angeordneten elektrisch, mechanisch oder pneumatisch betätigbaren Verriegelungseinrichtung (3) zum Festhalten des Steckers nach dem Einführen in die Steckeraufnahme (2), **dadurch gekennzeichnet**, daß die Verriegelungseinrichtung (3) lösbar mit dem Aufnahmeteil (1) verbunden ist, wobei sowohl die Verriegelungseinrichtung (3) als auch das Aufnahmeteil (1) miteinander korrespondierende Haltemittel aufweisen, mit denen die Verriegelungseinrichtung (3) am Aufnahmeteil (1) festsetzbar ist.

2. Prüfeinrichtung nach Anspruch 1, dadurch gekennzeichnet, daß die Haltemittel aus in das Aufnahmeteil (1) eingedrehte Feststellschrauben (4) und einer Andruckfläche (5) eines in ein Gehäuseteil (7) der Verriegelungseinrichtung (3) eingebrachten Langloches (6) bestehen, wobei sich die Köpfe der Schrauben (4) an der Andruckfläche (5) abstützen.

3. Prüfeinrichtung nach Anspruch 1, dadurch gekennzeichnet, daß das Aufnahmeteil (1) mit einer Führungsnut (11) versehen ist, in der die Verriegelungseinrichtung (3) einliegt.

4. Prüfeinrichtung nach Anspruch 3, dadurch gekennzeichnet, daß die Führungsnut (11) in ihrer Breite etwa der Breite des Gehäuseteiles (7) entspricht.

5. Prüfeinrichtung nach Anspruch 1, dadurch gekennzeichnet, daß das Aufnahmeteil (1) in einer ortsfesten Halterung (9) gehalten ist.

## Claims

1. A testing apparatus for testing a plug which is provided with cables, for locating and/or contacting defects, comprising a receiving portion (1) having a plug receiving means (2) adapted to the outside contour of a given plug, and a respective electrically, mechanically or pneumatically actuable locking device (3) arranged in one or more side regions of the plug receiving means (2) for holding the plug fast after insertion into the plug receiving means (2), characterised in that the locking device (3) is releasably connected to the receiving portion (1), wherein both the locking device (3) and also the receiving portion (1) have mutually corresponding holding means with which the locking device (3) can be fixed to the receiving portion (1).

2. A testing apparatus according to claim 1 characterised in that the holding means comprise securing screws (4) which are screwed into the receiving portion (1) and a contact pressure surface (5) of a slot (6) provided in a housing portion (7) of the locking device (3), the heads of the screws (4) bearing against the contact pressure surface (5).

3. A testing apparatus according to claim 1 characterised in that the receiving portion (1) is provided with a guide groove (11) in which the locking device (3) lies.

4. A testing apparatus according to claim 3 characterised in that the guide groove (11) approximately corresponds in width to the width of the housing portion (7).

5. A testing apparatus according to claim 1 characterised-in that the receiving portion (1) is held in a stationary holder (9).

## Revendications

1. Dispositif d'essai pour le contrôle d'une prise, qui est munie de câbles, en termes de défaut d'encliquetage et/ou de contact, comportant une partie de réception (1), qui présente un réceptacle de prise (2) adapté au contour extérieur d'une prise déterminée, ainsi qu'un dispositif de verrouillage (3) à commande électrique, mécanique ou pneumatique placé dans une ou plusieurs zones latérales du réceptacle de prise (2) pour retenir la prise après son introduction dans le réceptacle de prise (2), caractérisé en ce que le dispositif de verrouillage (3) est relié de manière amovible à la partie de réception (1), le dispositif de verrouillage (3) et la partie de réception (1) présentant chacun des moyens de retenue en correspondance mutuelle, par lesquels le dispositif de verrouillage (3) peut être maintenu sur la partie de réception (1).

2. Dispositif d'essai selon la revendication 1, caractérisé en ce que les moyens de retenue sont constitués de vis de fixation (4) vissées dans la partie de réception (1) et d'une surface de serrage (5) d'un trou allongé (6) ménagé dans une partie formant boîtier (7) du dispositif de verrouillage (1), les têtes des vis (4) s'appuyant contre la surface de serrage (5).

3. Dispositif d'essai selon la revendication 1, caractérisé en ce que la partie de réception (1) est munie d'une rainure de guidage (11), dans laquelle se place le dispositif de verrouillage (3).

4. Dispositif d'essai selon la revendication 3, caractérisé en ce que la rainure de guidage (11) a une largeur qui correspond environ à la largeur de la partie formant boîtier (7).

5. Dispositif d'essai selon la revendication 1, caractérisé en ce que la partie de réception (1) est tenue dans un support fixe (9),
